# EUROPEAN PATENT SPECIFICATION

(11) **EP 0 546 731 B1**
(45) Date of publication and mention of the grant of the patent: **26.06.1996**
(21) Application number: 92310855.9
(22) Date of filing: 27.11.1992
(51) Int. Cl.: H01L 23/495, H01L 25/18, H01L 25/07

(54) **Internal wiring structure of a semiconductor device**
Innere Leiterstruktur einer Halbleiteranordnung
Structure de conducteurs internes d'un dispositif semi-conducteur

(30) Priority: 10.12.1991 JP 324876/91
(43) Date of publication of application: 16.06.1993
(73) Proprietor: FUJI ELECTRIC CO. LTD., Kawasaki 210 (JP)
(72) Inventor: Iida, Kiyoshi, Matsumoto-shi, Nagano 390 (JP); Fujitaka, Hisashi, Kounosu-shi, Saitama 365 (JP)
(74) Representative: Topley, Paul

(56) References cited:
- EP-A- 0 292 848
- EP-A- 0 427 143
- EP-A- 0 455 322
- DE-A- 3 516 995
- DE-A- 4 031 051
- US-A- 4 819 042

## Description

The present invention relates to the internal wiring structure of a semiconductor device applied to power transistor modules, and the like.

EP-A-0 427 143 describes a wiring arrangement for a semiconductor device wherein connections are made to semiconductors in the device by wire-bonding their terminals directly to a set of terminal strips extending along the rows of semiconductor elements.

EP-A-0 455 323 likewise shows a semiconductor device wherein direct wire-bonding of semiconductor element terminals to the lead-out terminals of a semiconductor device is effected.

In EP-A-0 292 848, the use of the casing of a semiconductor device as a soldering guide in a two-stage soldering process is described.

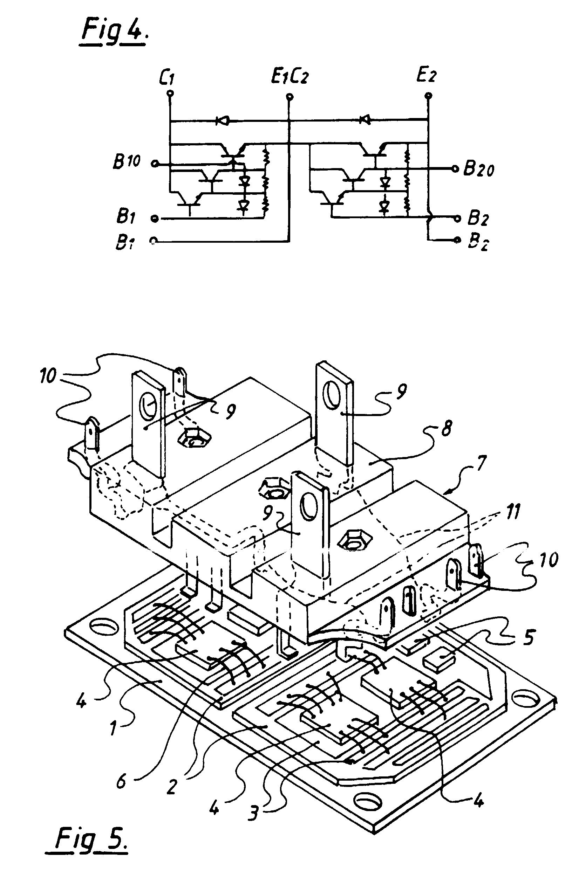

In the drawings, Figure 5 shows the conventional assembly structure of a power transistor module expressed by the equivalent circuit in Figure 4. In that Figure, the part 1 is a metallic substrate serving also as a heat dissipating plate, the part 2 is an insulation substrate mounted on the metallic substrate 1, the parts 3 are conductor patterns formed on the insulation substrate, the parts 4 are transistor chips (Darlington transistors), and the parts 5 are diode chips, the conductor patterns 3 and the electrodes of each conductor chip being interconnected by bonding wires 6. In the illustrated example, the circuit substrate is mounted with two sets of semiconductor chips, the sets being connected in parallel to increase their current-carrying capacity. The part 7 is a terminal block consisting of a series of main external lead-through terminals 9 and auxiliary external lead-through terminals 10 inserted into a case lid made of resin 8 (the case body is not shown in the Figures), the terminal block 7 being superposed on said circuit substrate assembly, with the terminal connections of the conductor patterns 3 on the substrate soldered by means of reflux soldering to the external lead-through terminals 9 and 10. The assembly is then assembled as one case body, and filled with resin gel fillers to seal the case and build a semiconductor device.

In this construction, the external lead-through terminals 9 and 10 on said terminal block 7 are each made by pressing and bending processes, with the tips of their legs aligned on the same plane and pressed into the same case lid 7. Locations requiring internal connection between the external lead-through terminals 9 and 10 are wired with insulated covered leads 11.

The internal wiring structure of the semiconductor device has the following problems:
1 ) The external lead-through terminals 9 and 10 attached to the terminal block 7 are fabricated piece by piece as individual parts with different shapes, making the material yield poor. Furthermore, in order for the terminal block 7 superposed on the conductor patterns 3 on the circuit substrate to be soldered reliably, it is necessary for the tips of the legs of each terminal (terminal connector) to be aligned very accurately, with the external lead-through terminals 9 and 10 pressed individually into the case lid 8. The process control necessary to assure flatness is complex and difficult.
2) In the terminal block 7, the use of flexible leads 11 for part of the internal wiring requires tedious and time-consuming manual wiring work, which not only increases the need for manpower, but also makes the part susceptible to an induction effect from the main circuit current because the internal wiring routes may not be consistent in all the cases because the leads 11 become loosened, causing undesirable oscillations and maloperation of the circuit.

The present invention has been made with a view to solving these problems, and is intended to provide an internal wiring structure of a semiconductor device in which internal leads that can cause oscillations and maloperation are eliminated, the material yield is improved, and the assembly process is simplified. These are the expressed objectives because the present internal wiring is intended to be applied to the power transistor modules mentioned earlier.

To achieve the above objectives, the internal wiring structure of the present invention consists of a wiring block in which a series of internal wiring is structured by a lead frame disposed between a terminal block and a circuit substrate, and a terminal connection on the circuit substrate side is interconnected via a wiring block with external lead-through terminals on the terminal block.

According to the present invention, there is provided a semiconductor device comprising a module case having a lid and a case wall and containing a circuit board comprising a metallic substrate having thereon an insulating layer on which are formed conductor patterns, a plurality of semiconductor chips being mounted on the substrate and wire-bonded to the conductor patterns to define first and second circuits, and a lead frame having a plurality of leads wherein each lead has a first connecting part connected by soldering to a respective terminal connection area of the conductor pattern and a second connecting part formed with a hole, the case lid having lead-through terminals, first ends of which pass through respective holes in the second connecting parts of the leads and are soldered thereto.

Furthermore, as a practical application of said structure, the wiring block may consist of a main circuit lead frame, and an auxiliary circuit lead frame, as well as a resin-moulded retaining frame to integrally retain each lead frame. It is desirable in this case for the lead frame to be subject to lead cutting and lead bending processes after it is moulded into the retaining frame.

In the above configuration, the lead frame of the wiring block is first bonded together with external lead-through terminals on the terminal block by soldering at the required locations. Then, the integral assembly of the terminal block and the wiring block is mounted on the circuit substrate, and the lead frame of the wiring block is soldered with conductor patterns on the substrate side, which completes the internal wiring.

The method according to the invention comprises arranging a plurality of semiconductor chips on a circuit board comprising a metallic substrate having thereon an insulating layer on which is formed a conductor pattern defining first and second electrical circuits each having respective terminal connection areas; wire-bonding the semiconductor chips to the conductor pattern to establish the first and second electrical circuits; assembling a lead frame with a case lid of a module case, the lead frame having a plurality of leads each of which has a first connecting part for connection to a respective terminal connection area of the conductor pattern and a second connecting part formed with a hole; wherein the lead frame consists of a conductive first circuit lead frame, a conductive second circuit lead frame, and an insulating resin-moulded retaining frame, into which the first circuit lead frame and the second circuit lead frame are integrally moulded; passing a number of lead-through terminals through the case lid so that first ends of the lead-through terminals pass through respective holes in the second connecting parts of the leads and are soldered thereto; assembling the circuit board and a case wall; and assembling the case lid and lead frame to the circuit board and case wall and bonding the first connecting parts with the terminal connection area by soldering, whereby the first and second circuit lead frames are subjected to lead cutting and bending processes after they are moulded into the retaining frame.

In this construction, because the series of the internal wiring routes interconnecting the external lead-through terminals on the terminal block with the conductor patterns on the circuit board are all formed on the lead frame, there is no need to provide additional lead wires. Moreover, the external lead-throuqh terminals on the main circuit incorporated into the terminal block and the external lead-through terminals on the auxiliary circuit do not need to be drawn around along the internal wiring routes either, and the thermal stresses associated with heat cycles can be absorbed into a lead frame made of elastic material. Therefore, terminals with a simple shape can be used as external lead-through terminals as a part serving both main and auxiliary circuits. Moreover, subjecting the main circuit lead frame and the auxiliary circuit lead frame moulded integrally into the retaining frame to lead cutting and bending processes simplifies the fabrication and assembly processes, and facilitates the control of the accuracy of the flatness of the connecting parts of the terminals relative to the circuit substrate.

Embodiments of the present invention will now be described in detail with reference to the drawings, parts identical with those in Figure 5 being given the same numerals.

In the drawings:
Figure 1 is a perspective view of a dismantled semiconductor device according to an embodiment of the present invention;
Figure 2 is a rear view of the terminal block in Figure 1;
Figure 3 is a plan view of the circuit board assembly in Figure 1;
Figure 4 is an equivalent circuit diagram of Figure 3; and
Figure 5 is a perspective view of a dismantled conventional semiconductor device.

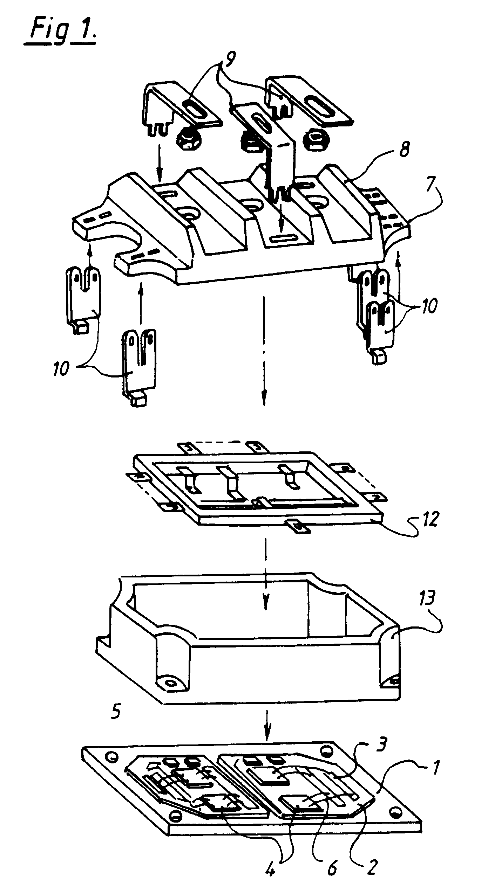

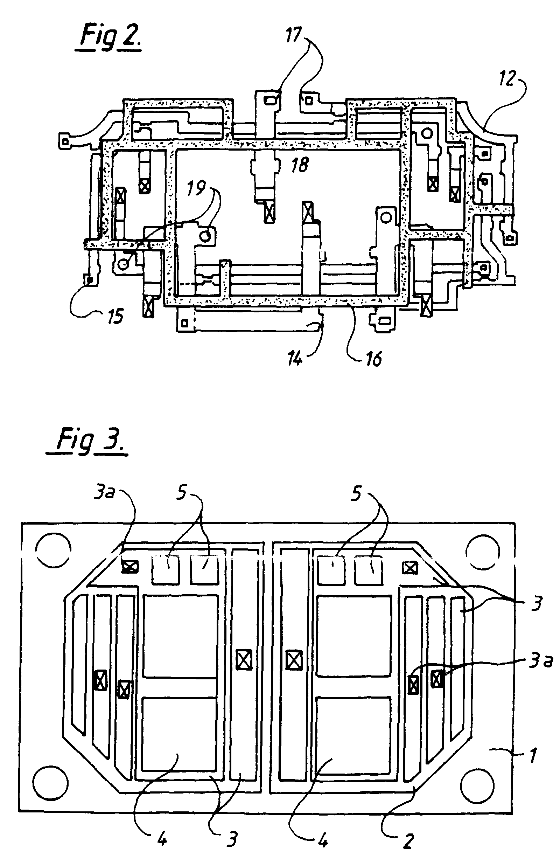

Referring first to Figure 1, there is seen a perspective view of a dismantled semiconductor device, wherein a new wiring block 12 is disposed on the underside of the terminal block 7, relative to the assembly consisting of a circuit board and the semiconductor chips shown in Figure 3 (the semiconductor chips have the same configuration as is shown in Figure 5). Moreover, the conductor patterns 3 on the circuit board are internally wired with external lead-through terminals 9 and 10 on the terminal block 7 via said wiring block 12, the assembly being assembled with a case wall 13 as an enclosure to construct a semiconductor device.

The terminal block 7 uses identically shaped terminal parts for the external lead-through terminals 9 on the main circuit and the external lead-through terminals 10 on the auxiliary circuit, which are then pressed into the case. At the same time, the wiring block 12 with its construction detail shown in Figure 2 consists of the main circuit lead frame 14 and the auxiliary circuit lead frame 15 in which series of wiring routes, divided for the main circuit, and the auxiliary circuit, are press-formed on one lead frame, while the retaining frame 16 is made of resin in which the lead frames 14 and 15 are laid above and below, and are moulded integrally. Referring to the lead frames 14 and 15 in Figure 2, to connect parts 17 used and to connect said external lead-through terminals 9 and 10, square holes are drilled and the tips of the external lead-through terminals 9 and 10 are inserted into them. Thereafter, the connecting parts 18 shown by mark "x" in Figure 2, used to connect the terminal connections 3a, shown by mark "x" in Figure 3, designated on the conductor patterns 3 on the circuit substrate are made with lead frames that stand upright. The lead cutting process to eliminate unnecessary parts from the lead frames, and the lead bending process are carried out with the lead frames 14 and 15 moulded together, and retained in the retaining frame 16. Round holes 19 drilled at several locations in the lead frames 14 and 15 are used to insert positioning jigs used in the assembly of the wiring block 12.

The above semiconductor device is assembled using the following procedure. First, the wiring block 12 is superposed over the rear side of the terminal block 7, both soldered together with the square holes in the connections 17 of the lead frames 14, and 15 inserted with tips of the external lead-through terminals 9 and 10. Next, semiconductor chips are mounted on the circuit substrate through a separate process, and an assembly of said terminal block 7 with the wiring block 12 is mounted in place on an assembly of the substrate with the case 13, with the wiring block 12 superposed on the conductor patterns 3 on the circuit substrate. Moreover, the terminal connections 3a in the conductor patterns 3 are bonded with connections 18 formed upright on the lead frames 14 and 15 using a reflux soldering method. As a result, the series of internal wiring between the circuit assemblies and the terminal block is formed via the lead frames 14 and 15 on the wiring block 12.

The internal wiring structure according to the present invention structured as described above has the following effects:
1) Because the series of the internal wiring interconnecting the external lead-through terminals mounted on the terminal block with the conductor patterns on the circuit substrate side are all formed on the lead frames of the wiring block, it is not necessary to dispose any additional lead wires. Moreover, the external lead-through terminals on the main circuit incorporated into the terminal block and the external lead-through terminals on the auxiliary circuit need not be drawn around along the internal wiring routes, and the thermal stresses associated with the heat cycles can be absorbed into a lead frame made of elastic material. Thus terminals with a simple shape can be used as external lead-through terminals as a part serving both main and auxiliary circuits. Therefore, identically shaped parts can be used in the external lead-through terminals, leading to a largely improved material yield as compared with a conventional internal wiring construction, in which each individually shaped external lead-through terminal that is inserted in a terminal block, is soldered directly to a circuit substrate, and the lead wires are connected to parts of the external lead-through terminals. Moreover, the present structure facilitates the control of the accuracy of the flatness of the connecting parts of the terminals relative to the circuit substrate, and reduces the need for manpower to assemble the internal wiring since lead wires are eliminated.
2) Furthermore, not using lead wires in the internal wiring will eliminate variation in the internal wiring paths, and will standardise the paths as per design requirements. Therefore, an unwanted oscillation or a malfunction in the circuit resulting from a main circuit current caused by lead wires which have wiring paths that are not regularly arranged can be reliably avoided, thereby improving the operation characteristics of the semiconductor device.
3) Moreover, the application of lead cutting and bending processes to the main circuit lead frame and the auxiliary circuit lead frame integrally moulded to the retaining frame simplifies the fabrication and assembly processes, and enables a highly accurate control of the flatness of the terminal connecting parts of the lead frame relative to the circuit substrate.

## Claims

1. A semiconductor device comprising a module case (13) having a lid (8) and a case wall (13) and containing a circuit board comprising a metallic substrate (1) having thereon an insulating layer (2) on which are formed conductor patterns (3), a plurality of semiconductor chips (4) being mounted on the substrate (1 ) and wire-bonded to the conductor patterns (3), to define first and second circuits, and a lead frame (12) having a plurality of leads (14, 15) wherein each lead (14, 15) has a first connecting part (18) connected by solder to a respective terminal connection area (3a) of the conductor pattern (3) and a second connecting part (17) formed with a hole, the case lid (8) having lead-through terminals (9, 10), first ends of which pass through respective holes in the second connecting parts (17) of the leads (14, 15) and are soldered thereto.

2. A semiconductor device as claimed in Claim 1, characterised in that the lead frame (12) consists of a first circuit lead frame (14), a second circuit lead frame (15), and a resin-moulded retaining frame (16), into which the first circuit lead frame (14), and second circuit lead frame (15) are integrally moulded.

3. A method of manufacturing a semiconductor device as claimed in Claim 2, comprising:
arranging a plurality of semiconductor chips (4) on a circuit board comprising a metallic substrate (1) having thereon an insulating layer (2) on which is formed a conductor pattern (3) defining first and second electrical circuits each having respective terminal connection areas (3a);
wire-bonding the semiconductor chips (4) to the conductor pattern (3) to establish the first and second electrical circuits;
assembling a lead frame (12) with a case lid (8) of a module case (13), the lead frame (12) having a plurality of leads (14, 15) each of which has a first connecting part (18) for connection to a respective terminal connection area (3a) of the conductor pattern (3) and a second connecting part (17) formed with a hole;
wherein the lead frame (12) consists of a conductive first circuit lead frame (14), a conductive second circuit lead frame (15), and an insulating resin-moulded retaining frame (16), into which the first circuit lead frame (14) and the second circuit lead frame (15) are integrally moulded;
passing a number of lead-through terminals (9, 10) through the case lid (8) so that first ends of the lead-through terminals (9, 10) pass through respective holes (17) in the second connecting parts of the leads (14, 15) and are soldered thereto;
assembling the circuit board and a case wall (13); and
assembling the case lid (8) and lead frame (12) to the circuit board and case wall (13) and bonding the first connecting parts (18) with the terminal connection area (3a) by soldering,
whereby the first and second circuit lead frames (14, 15) are subjected to lead cutting and bending processes after they are moulded into the retaining frame (16).

## Patentansprüche

1. Halbleiteranordnung, umfassend ein Bauteil-Gehäuse (13), das einen Deckel (8) und eine Gehäuse-Wand (13) hat und eine gedruckte Schaltung enthält, umfassend ein metallisches Substrat (1), auf dem sich eine isolierende Schicht (2) befindet, auf der Leiterbahnen (3) ausgebildet sind, eine Mehrzahl von Halbleiter-Chips (4), die auf dem Substrat (1) befestigt sind und mit den Leiterbahnen (3) drahtverbunden sind, um eine erste und eine zweite Schaltung und ein Leiter-Gerüst (12) zu definieren, das eine Mehrzahl von Leitern (14, 15) hat, worin jeder Leiter (14, 15) einen ersten verbindenden Abschnitt (18) hat, der mit dem jeweiligen Anschluß-Verbindungs-Bereich (3a) der Leiterbahnen (3) durch ein Lötmittel verbunden ist, und einen zweiten verbindenden, mit einem Loch ausgebildeten Abschnitt (17) hat, und der Gehäusedeckel (8) Durchführungsklemmen (9, 10) hat, deren Enden sich zunächst durch die jeweiligen Löcher in den zweiten verbindenden Abschnitten (17) der Leiter (14, 15) erstrecken und daran angelötet sind.

2. Halbleiteranordnung nach Anspruch 1, dadurch gekennzeichnet, daß das Leiter-Gerüst (12) aus einem ersten Schaltungs-Leiter-Gerüst (14), einem zweiten Schaltungs-Leiter-Gerüst (15), und einen aus Kunststoff geformten Halterahmen (16) besteht, in dem das erste Schaltungs-Leiter-Gerüst (14), und das zweite Schaltungs-Leiter-Gerüst (15) vollständig eingepreßt sind.

3. Verfahren zur Herstellung einer Halbleiteranordnung nach Anspruch 2, umfassend:
das Anordnen einer Mehrzahl von Halbleiter-Chips (4) auf einer gedruckten Schaltung, die ein metallisches Substrat (1) umfaßt, auf dem sich eine isolierende Schicht (2) befindet, auf der Leiterbahnen (3) ausgebildet sind, die eine erste und eine zweite Schaltung definieren, von denen jede jeweils Anschluß-Verbindungs-Bereiche (3a) hat;
das Drahtverbinden der Halbleiter-Chips (4) mit den Leiterbahnen (3) um die erste und zweite elektrische Schaltung aufzubauen;
das Zusammensetzen eines Leiter-Gerüstes (12) mit einem Gehäusedeckel (8) des Bauteil-Gehäuses (13), wobei das Leiter-Gerüst (12) eine Mehrzahl von Leitern (14, 15) hat, von denen jeder einen ersten verbindenden Abschnitt (18) zur Verbindung mit dem jeweiligen Anschluß-Verbindungs-Bereich (3a) der Leiterbahnen (3) und einen zweiten verbindenden, mit einem Loch ausgebildeten, Abschnitt (17) hat;
wobei das Leiter-Gerüst (12) aus einem leitenden ersten Schaltungs-Leiter-Gerüst (14), einem leitenden zweiten Schaltungs-Leiter-Gerüst (15), und einem isolierenden aus Kunststoff geformten Halterahmen (16) besteht, in den das erste Schaltungs-Leiter-Gerüst (14) und das zweite Schaltungs-Leiter-Gerüst (15) vollständig eingepreßt sind;
das Durchführen einer Anzahl von Durchführungsklemmen (9, 10) durch den Gehäusedeckel (8), so daß zunächst Enden der Durchführungsklemmen (9, 10) sich durch jeweilige Löcher (17) in den zweiten verbindenden Abschnitten der Leiter (14, 15) erstrecken und daran angelötet werden;
das Zusammensetzen der gedruckten Schaltung und einer Gehäuse-Wand (13); und
und das Zusammensetzen des Gehäusedeckels (8) und des Leiter-Gerüstes (12) mit der gedruckten Schaltung und der Gehäuse-Wand (13) und das Verbinden der ersten verbindenden Abschnitte (18) mit dem Anschluß-Verbindungs-Bereich (3a) durch Lötung; wobei das erste und zweite Schaltungs-Leiter-Gerüst (14, 15) Leiter-Schneide- und Biegeprozessen unterzogen werden, nachdem sie in den Halterahmen (16) eingepreßt worden sind.

## Revendications

1. Dispositif semi-conducteur comprenant une boîte module (13) ayant un couvercle (8) et une paroi de boîte (13) et contenant une carte de circuit comprenant un substrat métallique (1) ayant sur lui une couche isolante (2) sur laquelle sont formées des configurations conductrices (3), une pluralité de puces semi-conductrices (4) montées sur le substrat (1) et reliées par des fils aux configurations conductrices (3) pour définir de premier et second circuits; et un cadre conducteur (12) ayant une pluralité de conducteurs (14, 15), dans lequel chaque conducteur (14, 15) a une première partie de connexion (18) connectée par soudage à une zone de connexion terminale respective (3a) de la configuration conductrice (3), et une seconde partie de connexion (17) formée avec un trou, le couvercle de boîte (8) ayant des bornes (9, 10) traversantes, dont les premières extrémités traversent les trous respectifs dans les secondes parties de connexion (17) des conducteurs (14, 15) et y sont soudées.

2. Dispositif semi-conducteur selon la revendication 1, caractérisé en ce que le cadre conducteur (12) est constitué d'un premier cadre conducteur de circuit (14), d'un second cadre conducteur de circuit (15), et d'un cadre de retenue en résine moulée (16), dans lequel le premier cadre conducteur de circuit (14) et le second cadre conducteur de circuit (15) sont moulés d'un seul tenant

3. Procédé de fabrication d'un dispositif semi-conducteur selon la revendication 2, comprenant
- l'agencement d'une pluralité de puces semi-conductrices (4) sur une carte de circuit comprenant un substrat métallique (1) ayant sur lui une couche isolante (2) sur laquelle est formé une configuration conductrice (3), définissant un premier et un second circuits électriques, ayant chacun des zones respectives de connexion terminale (3a);
- la liaison par fils des puces semi-conductrices (4) aux configurations conductrices (3), pour établir les premier et second circuits électriques;
- l'assemblage d'un cadre conducteur (12) avec un couvercle de boîte (8) d'une boîte module (13), le cadre conducteur (12) ayant une pluralité de conducteurs (14, 15), chacun d'eux ayant une première partie de connexion (18) pour sa connexion à une zone de connexion terminale respective (3a) de la configuration conductrice (3), et une seconde partie de connexion (17) formée avec un trou;
- dans lequel le cadre conducteur (12) est constitué d'un premier cadre conducteur de circuit (14), un second cadre conducteur de circuit (15) et un cadre isolant de retenue en résine moulée (16), dans lequel le premier cadre conducteur de circuit (14) et le second cadre conducteur de circuit (15) sont moulés d'un seul tenant;
- le passage d'un certain nombre de bornes (9, 10) traversantes à travers le couvercle de boîte (8), de telle sorte que les premières extrémités des bornes (9, 10) traversantes traversent les trous respectifs (17) dans les secondes parties de connexion des conducteurs (14, 15) et y soient soudées;
- l'assemblage de la carte de circuit et d'une paroi de boîte (13); et
- l'assemblage du couvercle de boîte (8) et du cadre conducteur (12) à la carte de circuit et la paroi de boîte (13), et la liaison des premières parties de connexion (18) avec la zone terminale de connexion (3a) par soudage;
- grâce à quoi les premier et second cadres conducteurs de circuit (14, 15) sont soumis à des traitements de coupe et de courbure de conducteurs après avoir été moulés dans le cadre de retenue (16).
